# EUROPEAN PATENT APPLICATION

(11) **EP 4 362 622 A1**
(43) Date of publication of application: **01.05.2024**
(21) Application number: 23206879.1
(22) Date of filing: 31.10.2023
(51) Int. Cl.: H05K 9/00

(54) **STATIC ELECTRICITY RELEASING STRUCTURE FOR CONTROLLER, CONTROLLER AND VEHICLE**

(30) Priority: 31.10.2022 CN 202211353972
(71) Applicant: Nio Technology (Anhui) Co., Ltd, Hefei City, Anhui 230601 (CN)
(72) Inventor: LIU, Shuaijie, Hefei City, 230601 (CN); SHI, Jiepei, Hefei City, 230601 (CN); LIN, Rongsheng, Hefei City, 230601 (CN); Yang, Tseng-Mau, Hefei City, 230601 (CN); ZHAO, Dong, Hefei City, 230601 (CN)
(74) Representative: Chung, Hoi Kan

(57) **Abstract**

The disclosure provides a static electricity releasing structure for a controller, a controller, and a vehicle, with a view to solving the problem of fine electronic components being prone to damage due to static electricity of existing controllers. To this end, the static electricity releasing structure for a controller of the disclosure comprises: a conductive panel, a first support boss, and an insulator, wherein the conductive panel is removably mounted at a port of the controller and used for electrostatic discharge; the first support boss is arranged on the conductive panel in such a way that a gap is formed between the conductive panel and an intermediate plateof the controller; and the insulator is arranged in the gap for reducing contact area between the conductive panel and the intermediate plate.

## Description

### TECHNICAL FIELD

The disclosure relates to the technical field of controllers, and particularly provides a static electricity releasing structure for a controller, a controller and a vehicle.

### BACKGROUND

A controller is a small electronic element indispensable in modem life and widely used in all corners of life. For example, cell phones, computers, refrigerators, cars, airplanes and even rockets have to use a controller. A controller has simple functions of signal transmission and current conduction, and acts as a bridge to connect electrical modules and components of various units into a complete system. Existing controllers in daily use will produce static electricity, and fine electronic elements are prone to damage due to the static electricity of the controllers, which leads to an increased maintenance cost and thus brings poor experience to users.

Accordingly, there is a need in the field for a static electricity releasing structure for a controller to solve the above problem.

### SUMMARY

The disclosure is intended to solve the above technical problem, namely, to solve the problem that fine electronic components are prone to damage due to static electricity of the existing controllers, which leads to increased maintenance cost.

In a first aspect, the disclosure provides a static electricity releasing structure for a controller. The static electricity releasing structure comprises a conductive panel, a first support boss, and an insulator wherein the conductive panel is removably mounted to an intermediate plate of the controller and used for electrostatic discharge; the first support boss is arranged on the conductive panel in such a way that a gap is formed between the conductive panel and the intermediate plate; and the insulator is arranged in the gap for reducing contact area between the conductive panel and the intermediate plate.

With the above technical solution, the static electricity releasing structure for a controller of the disclosure comprises a conductive panel, a first support boss, and an insulator, wherein the conductive panel is removably mounted to an intermediate plate of the controller and used for electrostatic discharge; the first support boss is arranged on the conductive panel in such a way that a gap is formed between the conductive panel and the intermediate plate of the controller; and the insulator is arranged in the gap for reducing contact area between the conductive panel and the intermediate plate. The static electricity releasing structure of the disclosure is provided with the conductive panel, and the conductive panel is provided with the first support boss and the insulator, so that the gap is formed between the conductive panel and the intermediate plate, so as to reduce the contact area between the conductive panel and the intermediate plate to discharge static electricity of the controller to avoid damage to the fine electronic components, reducing maintenance cost.

In a preferred technical solution of the static electricity releasing structure, the controller comprises a top cover, a bottom cover and a circuit board arranged between the top cover and the bottom cover, the intermediate plate being arranged at an end of the top cover, and the gap being formed between the conductive panel and the intermediate plate; and the static electricity releasing structure further comprises a mounting boss, the mounting boss being arranged on the intermediate plate, and the mounting boss being arranged corresponding to and abutting against an upper portion of the first support boss, so as to increase the size of the gap.

In this solution, by providing the mounting boss, the size of the gap formed between the conductive panel and the intermediate plate is further increased, which further avoids excess contact between the conductive panel and the controller and in turn improves the electrostatic discharge.

In a preferred technical solution of the static electricity releasing structure, the static electricity releasing structure further comprises a second support boss, the second support boss being arranged on the intermediate plate, and the second support boss being arranged corresponding to and abutting against a lower portion of the first support boss, so as to increase the size of the gap.

In this solution, by providing the second support boss, the size of the gap between the conductive panel and the intermediate plate is further increased, which further avoids excess contact between the conductive panel and the controller and thus improves the electrostatic discharge.

In a preferred technical solution of the static electricity releasing structure, the first support boss extends from an upper side of the conductive panel to a lower side of the conductive panel in such a way that the gap between the conductive panel and the intermediate plate is uninterrupted.

In this solution, since the first support boss extends from the upper side of the conductive panel to the lower side of the conductive panel, the gap between the conductive panel and the intermediate plate is kept uniform and uninterrupted, thus avoiding contact between the conductive panel and the intermediate plate to ensure the electrostatic discharge.

In a preferred technical solution of the static electricity releasing structure, the static electricity releasing structure further comprises a first bevel and a second bevel, wherein the first bevel is configured at a bottom edge of the conductive panel, the second bevel is configured at an end of the bottom cover, and the first bevel and the second bevel are arranged corresponding to each other for increasing the contact area between the conductive panel and the bottom cover so as to divert currents from the conductive panel to the bottom cover.

In this solution, with the first bevel and the second bevel, the contact area between the conductive panel and the bottom cover can be increased, which in turn improves the electrostatic discharge effect while the conductive panel is further connected to the bottom cover.

In a preferred technical solution of the static electricity releasing structure, the first bevel is in interference fit with the second bevel.

In this solution, the first bevel being in interference fit with the second bevel provides the advantages of improving robustness of the connection between the conductive panel and the bottom cover and improving the electrostatic discharge effect.

In a preferred technical solution of the static electricity releasing structure, a connector is arranged at an end of the circuit board, the connector is provided with a metal housing, and the static electricity releasing structure further comprises a conductive elastic body, the conductive elastic body connecting the metal housing to the intermediate plate.

In this solution, when the metal housing of the connector is connected to the intermediate plate by means of the conductive elastic body, static electricity in a nearby area may be transferred to the metal housing of the connector of the circuit board through the intermediate plate via the conductive elastic body, and then discharged via a grounding wire harness plugged into the connector, so that the electrostatic discharge effect is further improved.

In a preferred technical solution of the static electricity releasing structure, the static electricity releasing structure further comprises a grounding wire harness, the grounding wire harness being connected to the connector for discharging static electricity by shunting.

In a second aspect, the disclosure further provides a controller, comprising a static electricity releasing structure as described in the foregoing preferred solutions.

The controller in this technical solution comprises a static electricity releasing structure as in any technical solution of the disclosure, and thus the controller has all the technical effects of the static electricity releasing structure as in any technical solution of the disclosure.

In a third aspect, the disclosure further provides a vehicle, comprising a controller as described in the second aspect.

The vehicle of the technical solution comprises a controller as in any technical solution of the disclosure, and thus the vehicle has all the technical effects of the controller as in any technical solution of the disclosure.

### BRIEF DESCRIPTION OF DRAWINGS

Preferred implementations of the disclosure are described below with reference to the accompanying drawings, in which:
FIG. 1 is a diagram of an overall structure of a controller of the disclosure;
FIG. 2 is an exploded view of parts of the controller of the disclosure;
FIG. 3 is a structural diagram of a conductive panel of the disclosure;
FIG. 4 is a structural diagram of an intermediate plate of the disclosure;
FIG. 5 is a structural diagram of a bottom cover of the disclosure.

### List of reference numerals:

1. Intermediate plate; 2. Conductive elastic body; 3. Circuit board; 4. Insulator; 5. Conductive panel; 6. Bottom cover; 7. First support boss; 8. Top cover; 9. Through hole; 10. Mounting boss; 11. Second support boss; 12. First bevel; 13. Second bevel; 14. Connector.

### DETAILED DESCRIPTION OF THE EMBODIMENTS

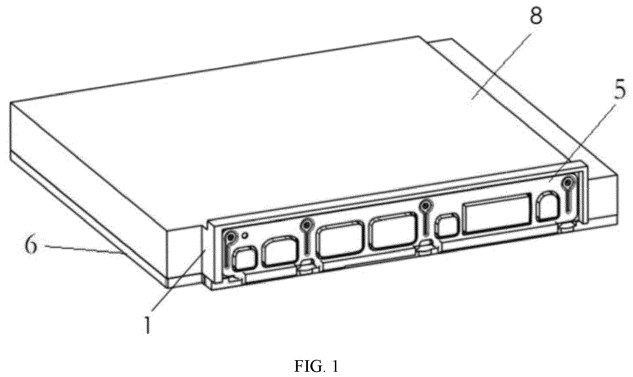

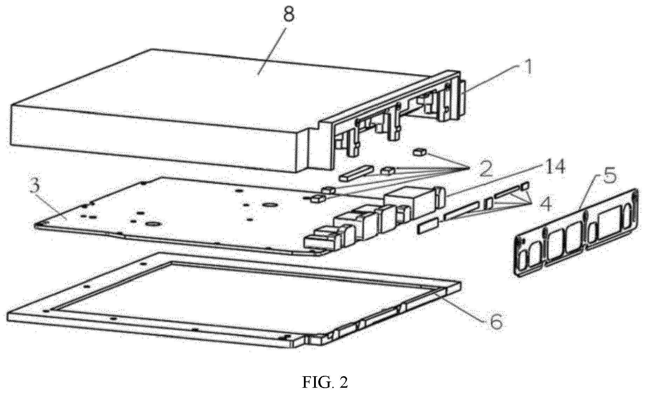

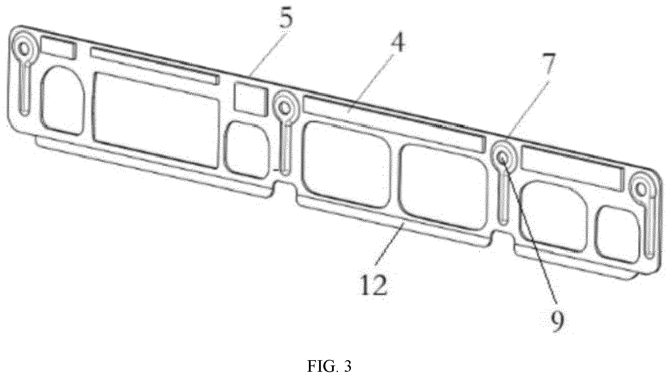

FIG. 1 is a diagram of an overall structure of a controller of the disclosure, FIG. 2 is an exploded view of parts of the controller of the disclosure, and FIG. 3 is a structural diagram of a conductive panel of the disclosure. A static electricity releasing structure of the disclosure for a controller may generally comprise a conductive panel 5, a first support boss 7 and an insulator 4. The conductive panel 5 is removably mounted at a port 8 of the controller and used for electrostatic discharge. The first support boss 7 is arranged on the conductive panel 5 in such a way that a gap is formed between the conductive panel 5 and an intermediate plate 1 of the controller. The insulator 4 is arranged in the gap for reducing contact area between the conductive panel 5 and the intermediate plate 1.

The static electricity releasing structure of the disclosure is provided with the conductive pane 5, and the conductive panel 5 is provided with the first support boss 7 and the insulator 4 so that the gap is formed between the conductive panel 5 and the intermediate plate 1 to enable the contact area between the conductive panel 5 and the intermediate plate 1 to be reduced, so as to discharge static electricity of the controller to avoid damage to fine electronic elements, reducing maintenance cost while bringing users a better experience. In addition, the structure is simple and is easy to machine.

In this embodiment, the first support boss 7 and the insulator 4 are located on a back surface of the conductive panel 5 so that the gap is formed between the conductive panel 5 and the intermediate plate 1. The back surface of the conductive panel 5 is connected to the intermediate plate 1.

Further, an upper portion of the first support boss 7 is circular and provided with a through hole 9 for insertion of a screw. In addition, a lower portion of the first support boss 7 is in the form of a strip and extends downwards, which avoids excess contact between the upper and lower portions of the conductive panel 5 and the intermediate plate 1 and keeps a gap of a certain size between the conductive panel 5 and the intermediate plate 1.

It should be noted that the number of first support bosses 7 is not specifically defined, for example, four first support bosses 7 are provided, allowing the left portion, central portion, and right portion of the conductive panel 5 to be separated from the intermediate plate 1 by a gap of a certain size, and avoiding the problem of poor electrostatic discharge effect due to partial contact between the conductive panel 5 and the intermediate plate 1. Those skilled in the art may set the number according to an actual situation.

In this embodiment, the insulator 4 is comprised of a plurality of insulation blocks, and the insulation blocks are generally cuboids or spheres with a size and number depending on actual needs.

Further, A front surface of the insulator 4 is provided with an adhesive layer for bonding to the back surface of the conductive panel 5, and the back surface of the insulator 4 is also provided with an adhesive layer for bonding to the intermediate plate 1 to prevent the conductive panel 5 from warping which otherwise affects screwing during automated assembly.

It should be noted that there are no any limitations imposed on the specific location of the insulator 4 in the disclosure, for example, the insulator may be located in the upper and/or middle and/or lower portion of the back surface of the conductive panel 5, which may be set by those skilled in the art according to an actual situation.

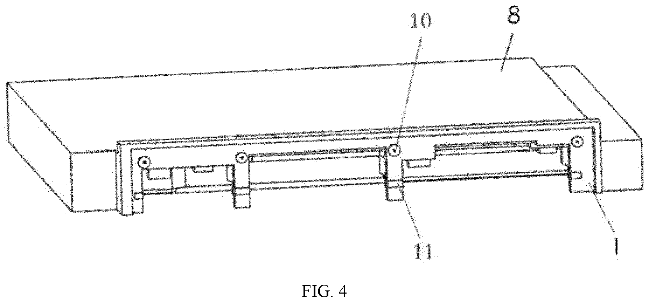

FIG. 4 is a structural diagram of the controller of the disclosure from another perspective. This embodiment is as shown in FIG. 4. Still with reference to FIG. 2, in an embodiment, the controller comprises a top cover 8, a bottom cover 6, and a circuit board 3 arranged between the top cover 8 and the bottom cover 6. The intermediate plate 1 is arranged at an end of the top cover 8, and the gap is formed between the conductive panel 5 and the intermediate plate 1. The static electricity releasing structure may further comprise a mounting boss 10. The mounting boss 10 is arranged on the intermediate plate 1. The mounting boss 10 is arranged corresponding to an upper portion of the first support boss 7, and the mounting boss 10 abuts against upper portion of the first support boss 7, so as to increase the size of the gap. By providing the mounting boss 10, the size of the gap formed between the conductive panel 5 and the intermediate plate 1 is further increased, which further avoids excess contact between the conductive panel 5 and the controller and in turn improves the electrostatic discharge.

In this embodiment, the mounting boss 10 is generally in the form of a cylinder or cuboid, an end of the mounting boss 10 is in contact with the upper portion of the first support boss 7, the mounting boss 10 has a threaded hole, and the threaded hole and the through hole 9 are connected by means of a screw to achieve a detachable connection between the conductive panel 5 and the controller.

The number of mounting bosses 10 is equal to the number of first support bosses 7 to ensure structural integrity.

As shown in FIG. 4, in an embodiment, the static electricity releasing structure may further comprise a second support boss 11. The second support boss 11 is arranged on the intermediate plate 1, and the second support boss 11 is arranged corresponding to a lower portion of the first support boss 7, and the second support boss 11 abuts against the lower portion of the first support boss 7, so as to increase the size of the gap. By providing the second support boss 11, the size of the gap between the conductive panel 5 and the intermediate plate 1 is further increased, which further avoids excess contact between the conductive panel 5 and the controller to improve the electrostatic discharge.

In this embodiment, the second support boss 11 is generally integrally configured in the middle and/or lower portion of the intermediate plate 1, and the second support boss 11 is in contact with the lower portion of the first support boss 7, so that a gap is kept between the conductive panel 5 and the intermediate plate 1 to avoid contact between the conductive panel 5 and the intermediate plate 1, so as to improve the electrostatic discharge effect.

The number of second support bosses 11 is equal to the number of first support bosses 7, and the second support boss 11 has the same height as the mounting boss 10, so that the gap is of the same size from top to bottom to improve the electrostatic discharge effect.

It should be noted that there are no any limitations imposed on the specific shape of the second support boss 11 in the disclosure, for example, the second support boss 11 may be in the form of a cuboid or a transverse cylinder, which may be set by those skilled in the art according to an actual situation.

As shown in FIG. 3, in an embodiment, the first support boss 7 extends from an upper side of the back surface of the conductive panel 5 to a lower side of the back surface of the conductive panel 5, so that the gap between the conductive panel 5 and the intermediate plate 1 is uninterrupted. This avoids contact between the conductive panel 5 and the intermediate plate 1 and ensures the electrostatic discharge.

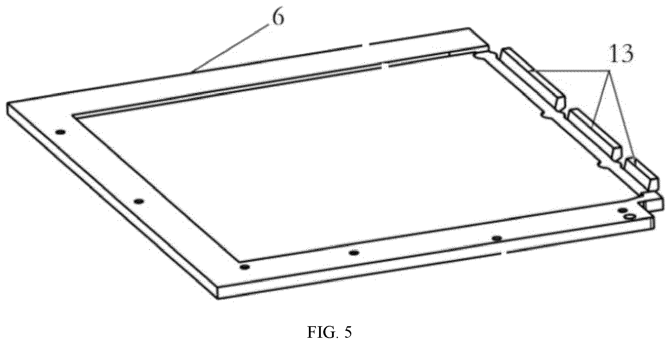

FIG. 5 is a structural diagram of a bottom cover of the controller of the disclosure. As shown in FIG. 5, in an embodiment, also referring to Figs. 1 and 2, the static electricity releasing structure may further comprise a first bevel 12 and a second bevel 13. The first bevel 12 is configured at a bottom edge of the conductive panel 5, the second bevel 13 is configured at an end of the bottom cover 6, and the first bevel 12 arranged corresponding to the second bevel 13 for increasing the contact area between the conductive panel 5 and the bottom cover 6 so as to divert currents from the conductive panel 5 to the bottom cover 6. With the first bevel 12 and the second bevel 13, the contact area between the conductive panel 5 and the bottom cover 6 can be increased, thereby further increasing the electrostatic discharge while the conductive panel 5 is further connected to the controller.

The first bevel 12 being in interference fit with the second bevel 13 provides the advantage of making the connection between the conductive panel 5 and the controller more robust. A front rim of the second bevel 13 has an upward vertical flange, and a front rim of the first bevel 12 abuts against the vertical flange, so that an interference fit between the first bevel 12 and the second bevel 13 is formed.

In this embodiment, both the first bevel 12 and the second bevel 13 are assembled from a plurality of interrupted rectangular strips.

As shown in Figs. 2, in an embodiment, a connector 14 is arranged at an end of the circuit board 3, the connector 14 is provided with a metal housing, and the static electricity releasing structure may further comprise conductive elastic body 2, the conductive elastic body 2 connecting the metal housing to the intermediate plate 1.

In this solution, when the metal housing of the connector 14 is connected to the intermediate plate 1 by means of the conductive elastic body 2, static electricity in a nearby area may be transferred to the metal housing of the connector of the circuit board 3 through the intermediate plate 1 via the conductive elastic body 2, and then discharged via a grounding wire harness plugged into the connector 14, so that the electrostatic discharge effect is further improved.

In this embodiment, the number of conductive elastic bodies 2 and the number of connectors 14 are identical and are provided in one-to-one correspondence, and the conductive elastic body 2 is located between the connector 14 and the metal housing to realize the electrostatic discharge.

Further, the conductive elastic body 2 may be of conductive plastic or conductive rubber.

It should be noted that the disclosure does not impose specific limitations on the shape of the conductive elastic body 2, and the conductive elastic body 2 may generally be ring-shaped or sheet-like, which may be set by those skilled in the art according to the actual situation.

In an embodiment not shown in the figures, the static electricity releasing structure may further comprise a grounding wire harness, the grounding wire harness being connected to the connector 14 for discharging static electricity. The grounding wire harness is plugged into the connector 14 at one end of and is connected to the floor of the vehicle at the other end to form a ground connection, so that electrostatic discharge by shunting is realized.

In a second aspect, the disclosure further provides a controller that may generally comprise a static electricity releasing structure in the above solution.

As shown in FIGS. 1 to 5, in an embodiment, the controller may generally comprise a top cover 8, an intermediate plate 1, a circuit board 3, a bottom cover 6, a conductive panel 5, and a connector 14. The top cover 8 and the bottom cover 6 are connected by a screw or by snap fit, which facilitates disassembly and maintenance. The top cover 8 and the bottom cover 6 are connected to form a cavity inside. The circuit board 3 is arranged inside the cavity and is connected to the bottom cover 6 by a screw, by bonding or by snap fit, to fix the circuit board 3. The intermediate plate 1 is integrally molded in or fixed to a front end of the top cover 8 by a screw.

In this embodiment, the mounting boss 10 is machined on an upper portion of the intermediate plate 1 and configured to abut against the upper portion of the first support boss 7 of the conductive panel 5, and a second support boss 11 is machined on a lower portion of the intermediate plate 1 and configured to abut against the lower portion of the first support boss 7 of the conductive panel 5. A front end of the bottom cover 6 has a second bevel 13 for connection with the first bevel 12 on the lower portion of the conductive panel 5.

It should be noted that there are no any limitations imposed on the overall shape of the controller in the disclosure, and the controller may be a in the form of a cuboid, and of course may be made into a cylinder in order to adapt to the space or the structure of a device that is interfaced therewith, which may be set by those skilled in the art according to an actual situation.

The controller in this technical solution comprises a static electricity releasing structure as in any technical solution of the disclosure, and thus the controller has all the technical effects of the static electricity releasing structure as in any technical solution of the disclosure.

In a third aspect, the disclosure further provides a vehicle, comprising a controller as described in the second aspect.

The vehicle of the technical solution comprises a controller as in any technical solution of the disclosure, and thus the vehicle has all the technical effects of the controller as in any technical solution of the disclosure.

It should be noted that, unless otherwise specified, the technical terms or scientific terms used in the disclosure shall have common meanings understood by persons skilled in the art to which the disclosure relates.

In the description of the disclosure, it should be understood that the orientation or position relationship indicated by the terms "central", "longitudinal", "transverse", "length", "width", "thickness", "upper", "lower", "front"; "rear", "left", "right", "vertical", "horizontal", "top", "bottom", "inner", "outer", "clockwise", "counterclockwise", "axial", "radial", "circumferential", etc. are based on the orientation or position relationship as shown in the accompanying drawings and are merely intended to facilitate and simplify the description of the disclosure, rather than indicating or implying that the device or element considered must have a particular orientation or be constructed and operated in a particular orientation, and therefore not to be construed as limiting the disclosure.

In addition, the terms "first", "second", etc. are merely for the purpose of description, and shall not be understood as any indication or implication of relative importance or any implicit indication of the number of technical features indicated. In the description of the disclosure, the term "a plurality of' means two or more, unless otherwise explicitly and specifically defined.

In the description of the disclosure, unless otherwise explicitly specified and defined, the terms such as "mount", "couple", "connect", and "fix" should be understood in a broad sense, for example, they may be a fixed connection, a detachable connection, or an integrated connection; may be a mechanical connection or an electrical connection; or may be a direct connection or an indirect connection by means of an intermediate medium, or may be communication between interiors of two elements or interaction between the two elements. For those of ordinary skill in the art, the specific meanings of the above terms in the disclosure can be understood according to specific situations.

In the disclosure, unless otherwise explicitly specified and defined, the first feature being "above" or "below" the second feature may refer to the first feature being in direct contact with the second feature, or the first feature being brought into contact with the second feature via a medium. In addition, the first feature being "above", "over", and "on" the second feature may refer to the first feature being directly above or obliquely above the second feature, or simply means that the level of the first feature is higher than that of the second feature. The first feature being "below", "beneath", and "under" the second feature may refer to the first feature being directly below and obliquely below the second feature, or simply means that the level of the first feature is less than that of the second feature.

Heretofore, the technical solutions of the disclosure have been described with reference to the preferred implementations shown in the accompanying drawings. However, those skilled in the art can readily understand that the scope of protection of the disclosure is apparently not limited to these specific implementations. Those skilled in the art may make equivalent changes or substitutions to the related technical features without departing from the principle of the disclosure, and all the technical solutions with such changes or substitutions shall fall within the scope of protection of the disclosure.

## Claims

1. A static electricity releasing structure for a controller, comprising: a conductive panel(5), a first support boss(7), and an insulator (4), wherein
the conductive panel(5) is removably mounted to an intermediate plate (1) of the controller and used for electrostatic discharge;
the first support boss(7) is arranged on the conductive panel(5) in such a way that a gap is formed between the conductive panel(5) and the intermediate plate (1); and
the insulator (4) is arranged in the gap for reducing contact area between the conductive panel(5) and the intermediate plate (1).

2. The static electricity releasing structure for a controller according to claim 1, wherein the controller comprises a top cover (8), a bottom cover (6) and a circuit board (3) arranged between the top cover (8) and the bottom cover (6), the intermediate plate (1) being arranged at an end of the top cover (8), and the gap being formed between the conductive panel(5) and the intermediate plate (1); and
the static electricity releasing structure further comprises a mounting boss (10), the mounting boss (10) being arranged on the intermediate plate (1), and the mounting boss (10) being arranged corresponding to and abutting against an upper portion of the first support boss(7), so as to increase the size of the gap.

3. The static electricity releasing structure for a controller according to claim 2, wherein the static electricity releasing structure further comprises a second support boss (11);
the second support boss (11) is arranged on the intermediate plate (1), and the second support boss (11) is arranged corresponding to and abuts against a lower portion of the first support boss(7), so as to increase the size of the gap.

4. The static electricity releasing structure for a controller according to claim 2, wherein the first support boss(7)extends from an upper side of the conductive panel(5) to a lower side of the conductive panel(5) in such a way that the gap between the conductive panel(5) and the intermediate plate (1) is uninterrupted.

5. The static electricity releasing structure for a controller according to any one of claims 2-4, wherein the static electricity releasing structure further comprises a first bevel (12) and a second bevel (13);
the first bevel (12) is configured at a bottom edge of the conductive panel(5), the second bevel (13) is configured at an end of the bottom cover (6), and the first bevel (12) and the second bevel (13) are arranged corresponding to each other for increasing the contact area between the conductive panel(5) and the bottom cover (6) so as to divert currents from the conductive panel(5) to the bottom cover (6).

6. The static electricity releasing structure for a controller according to claim 5, wherein the first bevel (12) is in interference fit with the second bevel (13).

7. The static electricity releasing structure for a controller according to any one of claims 2-4, wherein a connector (14) is arranged at an end of the circuit board (3) and the connector (14) is provided with a metal housing; and
the static electricity releasing structure further comprises a conductive elastic body (2), the conductive elastic body (2) connecting the metal housing to the intermediate plate (1).

8. The static electricity releasing structure for a controller according to any one of claims 2-4, wherein a fastener passes through the mounting boss (10) and the upper portion of the first support boss(7) to connect the conductive panel(5) to the intermediate plate (1).

9. A controller, comprising a static electricity releasing structure of any one of claims 1-8.

10. A vehicle, comprising a controller of claim 9.
